# EUROPEAN PATENT APPLICATION

(11) **EP 3 358 241 A1**
(43) Date of publication of application: **08.08.2018**
(21) Application number: 16877587.2
(22) Date of filing: 08.12.2016
(51) Int. Cl.: F21K 9/20, F21Y 115/10

(54) **EFFICIENT LED INTELLIGENT LIGHT SOURCE**

(30) Priority: 25.12.2015 CN 201511008300
(71) Applicant: Guagnzhou Tianxin Photoelectric Co., Ltd., Huadu District Guangzhou Guangdong (CN)
(72) Inventor: ZHANG, Wei, Guangzhou Guangdong 510440 (CN); XIAO, Liang, Guangzhou Guangdong 510440 (CN)
(74) Representative: Sun, Yiming
(86) International application number: PCT/CN2016/108993
(87) International publication number: WO 2017/107776

(57) **Abstract**

An efficient LED intelligent light source, comprising an encapsulation substrate and a chip unit arranged on the encapsulation substrate, wherein the chip unit comprises at least one bare chip unit and at least one wrapped chip unit formed by covering the surface of the bare chip unit with a layer of first fluorescent layer (a); colour temperatures of the bare chip unit and the wrapped chip unit are different; and a second fluorescent layer is further arranged to cover the bare chip unit and the wrapped chip unit. The efficient LED intelligent light source has good light-colour consistency and is even in light, and the light-colour continuity after colour mixing is enhanced, thereby avoiding the layering phenomenon of a light-mixed partition. An integrally encapsulated LED light source has good air tightness, high reliability and high light-colour quality and is convenient to manufacture.

## Description

### Field of the Invention

The present invention relates to the technical field of high power LED apparatuses, in particular, to an efficient LED intelligent light source.

### Description of Related Art

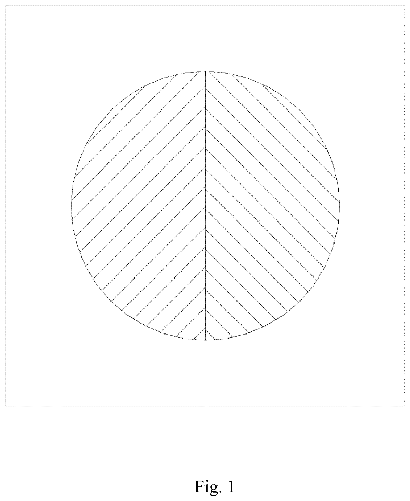

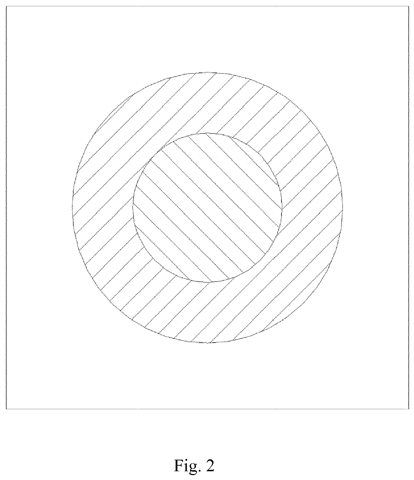

In an existing high power LED light source, one side of a substrate is manufactured to have one colour temperature, and the other side of the substrate is manufactured to have another colour temperature (as shown in Fig. 1); or manufacturing is carried out in circles, an inner circle is manufactured to have one colour temperature, an outer circle is manufactured to have another colour temperature, and the two different colour temperature regions are distinguished by building a blocking wall between the inner and outer circles (as shown in Fig. 2). By this manufacturing method, a process of separately building a blocking wall is needed to complete subsequent separation of distinguishing different colour temperatures, a single separated region is filled with a designated colour temperature, and it is difficult to ensure consistency of filling at a light emitting surface. Due to regional separation, light path manufacturing is difficult in subsequent mounting of a lens or a reflective bowl for mixing and adjusting light of different colour temperatures, the probability of occurrence of uneven mixing, colour cast, and uneven faculae is large, and the light-colour continuity is poor.

In addition, there is another method of fitting separate LED lamps to a circuit board. By the method, if manufacturing is carried out by using one high power lamp, colour mixing is uneven and glaring is relatively strong; if manufacturing is carried out by splicing a plurality of small sized lamps, it is difficult to ensure the fitness of the fitting, the light emitting directions are inconsistent, and the light-colour continuity is also reduced. Because a layer of circuit board is added by using the method of fitting separate LED lamps, the thermal resistance of the light source increases accordingly, and the reliability and the service life of the light source reduces accordingly.

### SUMMARY OF THE INVENTION

The present invention is directed to an efficient LED intelligent light source having good light-colour consistency and being even in light, and the light-colour continuity after colour mixing is enhanced, thereby avoiding the layering phenomenon of a light-mixed partition. An integrally encapsulated LED light source has good air tightness, high reliability and high light-colour quality and is convenient to manufacture.

To achieve the objective, the present invention provides an efficient LED intelligent light source, comprising an encapsulation substrate and a chip unit arranged on the encapsulation substrate, wherein the chip unit comprises at least one bare chip unit and at least one wrapped chip unit formed by covering the surface of the bare chip unit with a layer of first fluorescent layer; colour temperatures of the bare chip unit and the wrapped chip unit are different; and a second fluorescent layer is further arranged to cover the bare chip unit and the wrapped chip unit.

As a further improvement of the present invention, there is one colour temperature for the wrapped chip units, and the bare chip units and the wrapped chip units are arranged evenly and alternately with each other.

As a further improvement of the present invention, there are at least two colour temperatures for the wrapped chip units, and the bare chip units and the wrapped chip units of each colour temperature are arranged evenly and alternately with each other.

As a further improvement of the present invention, the bare chip unit consists of at least one blue chip.

As a further improvement of the present invention, the first fluorescent layer is of a transition phosphor.

As a further improvement of the present invention, the second fluorescent layer is of an encapsulation fluorescent glue.

As compared with the existing technology, the beneficial effects of the efficient LED intelligent light source of the present invention are as follows:
(1) By the LED light source formed by integrally encapsulating the wrapped chip unit formed by covering the first fluorescent layer once and the bare chip unit of a primary colour, the whole light emitting of the LED light source is in the same plane, the light-colour consistency is good, the light is even, and the light-colour continuity after colour mixing is enhanced, thereby avoiding the layering phenomenon of a light-mixed partition. In addition, the integrally encapsulated LED light source has good air tightness, high reliability and high light-colour quality and is convenient to manufacture, thereby being beneficial to fine scale production, such that the efficient LED intelligent light source can be widely applied to various indoor and outdoor intelligent lamps, and a gradient effect can be formed by mounting a plurality of different LED light sources together.
(2) The bare chip units and the wrapped chip units are arranged evenly and alternately with each other, thereby primarily achieving light-colour evenness.

The present invention becomes more clarified through the following description in combination with the figures, and the figures are used for interpreting the embodiments of the present invention.

### BRIEF DESCRIPTION OF THE DRAWINGS

Fig. 1 is a schematic diagram of a solution of a high power LED light source in the existing technology.
Fig. 2 is a schematic diagram of another solution of a high power LED light source in the existing technology.
Fig. 3 is a schematic planar structural diagram of an efficient LED intelligent light source of the present invention.
Fig. 4 is a schematic cross-sectional structural diagram of an efficient LED intelligent light source of the present invention.

### DESCRIPTION OF THE EMBODIMENTS

The embodiments of the present invention are described with reference to the figures, similar referential labels in the figures represent similar elements.

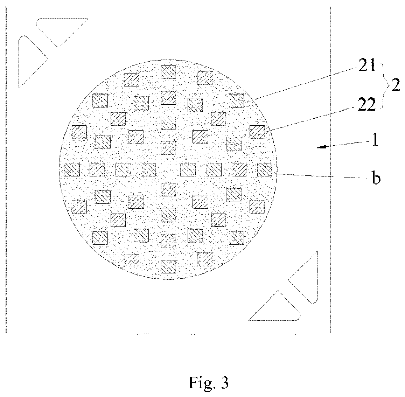

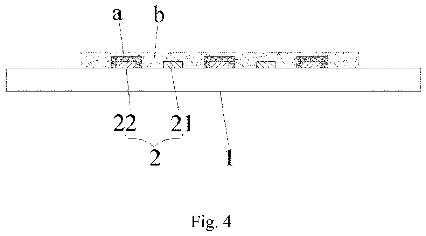

Referring to Figs. 3 and 4, the efficient LED intelligent light source includes an encapsulation substrate 1 and a chip unit 2 disposed on the encapsulation substrate 1. Specifically, the chip unit 2 comprises a plurality of bare chip units 21 and a plurality of wrapped chip units 22 formed by covering the surface of the bare chip unit 21 with a layer of first fluorescent layer a. The bare chip units 21 each consist of at least one chip. The chip generally adopts a blue chip, or may also adopt a violet chip. More specifically, colour temperatures of all the bare chip units 21 are the same, colour temperatures of all the wrapped chip units 22 are the same, and the colour temperature of the wrapped chip units 22 is different from that of the bare chip units 21 due to the function of the first fluorescent layer a. The surface of the plurality of bare chip units 21 and the surface of the plurality of wrapped chip units 22 are integrally covered by a layer of a second fluorescent layer b, so that a colour temperature of white light can be obtained by covering the bare chip units 21 of one colour temperature by a second fluorescent layer b, another colour temperature of white light can be obtained by covering the wrapped chip units 22 of another colour temperature by the second fluorescent layer b, and the colour temperatures are manufactured to satisfy requirements once, thereby implementing intelligent adjustment of the light source. The number of the plurality of bare chip units 21 and that of plurality of wrapped chip units 22 may be the same or different, but the bare chip units 21 and the wrapped chip units 22 are arranged alternately and evenly with each other, thereby primarily achieving light-colour evenness. The LED light source formed by integrally encapsulating the wrapped chip unit 22 formed by covering the first fluorescent layer a once and the bare chip unit 21 of a primary colour together through the second fluorescent layer b, the whole light emitting of the LED light source is in the same plane, the light-colour consistency is good, the light is even, and the light-colour continuity after colour mixing is enhanced, thereby avoiding the layering phenomenon of a light-mixed partition. In addition, the integrally encapsulated LED light source has good air tightness, high reliability and high light-colour quality and is convenient to manufacture, thereby being beneficial to fine scale production, such that the efficient LED intelligent light source can be widely applied to various indoor and outdoor intelligent lamps. More specifically, the first fluorescent layer a is of a transition phosphor, and the second fluorescent layer b is of an encapsulation fluorescent glue, so as to achieve the purpose of encapsulation. More specifically, the wrapped chip unit 22 and the bare chip unit 21 may be separately controlled and lightened. That is, during lightening, the wrapped chip unit 22 may be lightened only or the bare chip unit 21 may be lightened only, thereby achieving the purpose of satisfying different requirements.

In other embodiments, the chip unit 2 may also only include one bare chip unit 21 and one wrapped chip unit 22 formed by covering a layer of a first fluorescent layer a on the surface of the bare chip unit 21.

In other embodiments, the wrapped chip units 22 have two or more colour temperatures, and the wrapped chip units 22 and the bare chip units 21 of each colour temperature are arranged evenly and alternately with each other. The number of wrapped chip units 22 of each colour temperature may be the same or different, and the number of wrapped chip units 22 of each colour temperature and that of bare chip units 21 of each colour temperature may be the same or different, as long as the wrapped chip units 22 and the bare chip units 21 are arranged alternately and evenly with each other.

The present invention is described above with reference to the exemplary embodiments, but the present invention is not limited to the embodiments described above, and shall cover various modifications and equivalent combinations according to the essence of the present invention.

## Claims

1. An efficient LED intelligent light source, comprising: an encapsulation substrate and a chip unit disposed on the encapsulation substrate, **characterized in that**: the chip unit comprises at least one bare chip unit and at least one wrapped chip unit formed by covering the surface of the bare chip unit with a layer of first fluorescent layer; colour temperatures of the bare chip unit and the wrapped chip unit are different; a second fluorescent layer is further arranged to cover the bare chip unit and the wrapped chip unit.

2. The efficient LED intelligent light source according to claim 1, **characterized in that**: there is one colour temperature for the wrapped chip units, and the bare chip units and the wrapped chip units are arranged evenly and alternately with each other.

3. The efficient LED intelligent light source according to claim 1, **characterized in that**: there are at least two colour temperatures for the wrapped chip units, and the bare chip units and the wrapped chip units of each colour temperature are arranged evenly and alternately with each other.

4. The efficient LED intelligent light source according to any one of claims 1 to 3, **characterized in that**: the bare chip unit consists of at least one chip.

5. The efficient LED intelligent light source according to any one of claims 1 to 3, **characterized in that**: the first fluorescent layer is of a transition phosphor.

6. The efficient LED intelligent light source according to any one of claims 1 to 3, **characterized in that**: the second fluorescent layer is of an encapsulation fluorescent glue.
